# EUROPÄISCHE PATENTSCHRIFT

(11) **EP 1 532 071 B1**
(45) Veröffentlichungstag und Bekanntmachung des Hinweises auf die Patenterteilung: **23.11.2016**
(21) Anmeldenummer: 03792106.1
(22) Anmeldetag: 06.05.2003
(51) Int. Cl.: B81C 1/00

(54) **SCHICHTSYSTEM MIT EINER SILIZIUMSCHICHT UND EINER PASSIVIERSCHICHT, VERFAHREN ZUR ERZEUGUNG EINER PASSIVIERSCHICHT AUF EINER SILIZIUMSCHICHT UND DEREN VERWENDUNG**
LAYER SYSTEM COMPRISING A SILICON LAYER AND A PASSIVATION LAYER, METHOD FOR PRODUCING A PASSIVATION LAYER ON A SILICON LAYER AND THE USE OF SAID SYSTEM AND METHOD
SYSTEME STRATIFIE COMPORTANT UNE COUCHE DE SILICIUM ET UNE COUCHE DE PASSIVATION, PROCEDE POUR PRODUIRE UNE COUCHE DE PASSIVATION SUR UNE COUCHE DE SILICIUM, ET UTILISATION DUDIT SYSTEME ET DUDIT PROCEDE

(30) Priorität: 17.08.2002 DE 10237787
(43) Veröffentlichungstag der Anmeldung: 25.05.2005
(73) Patentinhaber: ROBERT BOSCH GMBH, 70442 Stuttgart (DE)
(72) Erfinder: LAERMER, Franz, 71263 Weil der Stadt (DE); MUELLER, Lutz, 72631 Aichtal (DE); BERNHARD, Winfried, 70839 Gerlingen (DE)
(86) Internationale Anmeldenummer: PCT/DE2003/001437
(87) Internationale Veröffentlichungsnummer: WO 2004/018348

(56) Entgegenhaltungen:
- EP-A- 0 822 586
- EP-A1- 0 895 276
- WO-A2-2004/016546
- DE-A- 19 847 455
- US-A- 5 604 380
- US-A- 5 646 439
- OHARA J ET AL: "A new deep reactive ion etching process by dual sidewall protection layer", 20000123; 20000123 - 20000127, 23 January 2000 (2000-01-23), pages 277-282, XP010377139,

## Beschreibung

Die Erfindung betrifft ein Schichtsystem mit einer Siliziumschicht und einer Passivierschicht, ein Verfahren zur Erzeugung einer Passivierschicht auf einer Siliziumschicht und Verwendung dieses Schichtsystems oder dieses Verfahrens nach Gattung der unabhängigen Ansprüche.

### Stand der Technik

Bei einem beispielsweise aus DE 44 20 962 C2 bekannten Verfahren zur Herstellung freitragender MEMS-Strukturen in Silizium (MEMS = "mikroelektromechanical structures") durch Kombination anisotroper und isotroper Ätztechniken werden zunächst sogenannte Trenchgräben oder tiefe Strukturen mit senkrechten Seitenwänden mittels eines reaktiven Plasmas anisotrop in ein Siliziumsubstrat eingeätzt. Nach Erreichen der gewünschten Ätztiefe wird dann nach einem länger andauernden Passivierschritt zur Abscheidung eines teflonartigen Films ein länger andauernder Ätzschritt durchgeführt, bei dem zunächst mittels Ionenbeschuss der Ätzgrund des Trenchgraben von einem gebildeten Teflonpolymer frei geräumt, und anschließend eine isotrope Unterätzung von zu erzeugenden freitragenden MEMS-Strukturen vorgenommen wird. Die senkrechten Seitenwände der Trenchgräben bleiben während dieser isotropen Unterätzung durch den zuvor aufgebrachten teflonartigen Film vor einem Ätzangriff geschützt. Die isotrope Unterätzung der erzeugten MEMS-Strukturen schreitet gemäß DE 44 20 962 C2 in dem Substratmaterial Silizium rein zeitkontrolliert voran.

Zur Abscheidung des teflonartigen Films wird bevorzugt ein Fluorkohlenwasserstoff mit möglichst niedrigem Fluor-zu-Kohlenstoff-Verhältnis von vorzugsweise 2:1, besonders bevorzugt kleiner als 2:1, beispielsweise 1,5:1, eingesetzt, wozu sich besonders Fluorkohlenwasserstoffe wie C₄F₆, C₅F₈, C₄F₈ oder C₃F₆ eignen. Zur Ätzung von Silizium wird bevorzugt ein an sich isotrop ätzendes, Fluorradikale lieferndes Prozessgas wie SF₆ herangezogen.

In DE 198 47 455 A1 ist vorgeschlagen worden, bei einem isotropen Unterätzen über vergrabene Oxidschichten eine vertikale Begrenzung der isotropen Unterätzung vorzunehmen. Insbesondere wird dort ein Ätzangriff auf die MEMS-Strukturen durch ein Zwischenoxid, das die MEMS-Struktur von einer Opferschicht aus Silizium trennt, verhindert. Daneben ist dort beschrieben, dass die isotrope Unterätzung statt mit Hilfe von Fluorradikalen aus einer Plasmaentladung auch unter Verwendung von spontan und plasmalos siliziumätzenden Fluorverbindungen wie XeF₂, ClF₃ oder BrF₃ erfolgen kann. Diese Verbindungen spalten nach Adsorption und Chemiesorption auf einer Siliziumoberfläche spontan Fluorradikale ab, was zu einem isotropen Ätzabtrag des Siliziums durch Bildung von Siliziumtetrafluorid führt. Dabei ist gleichzeitig eine sehr hohe Selektivität gegenüber Nichtsiliziummaterialien wie teflonartigen oder anderweitig zusammengesetzten Passivierschichten gegeben. Insbesondere wird Fotolack von ClF₃ praktisch nicht messbar angegriffen, so dass einerseits eine Passivierung von nicht zu ätzenden Teilen eines Siliziumwafers besonders leicht möglich ist, andererseits aber auch schon sehr dünne Passivierschichten genügen, um einen vollständigen Schutz vor einem Ätzangriff zu gewährleisten. Vielfach ist das auf Siliziumoberflächen in der Regel ohnehin vorhandene sogenannte "native" Siliziumoxid bereits in der Lage, minutenlang einem ChlortrifluoridAngriff standhalten, ohne dass darunter befindliches Silizium geätzt würde.

Ein weiterer Aspekt bei der Verwendung von ClF₃ und in eingeschränktem Maße auch BrF₃ ist die an sich geringe Reaktivität dieser hochoxidierenden Fluorverbindungen gegenüber Silizium, was dazu führt, dass eine damit durchgeführte Ätzung über einen weiteren Parameterbereich reaktionskontrolliert abläuft und nicht durch einen Stoff-transport limitiert wird. Insofern können auch große Unterätzweiten realisiert werden, ohne dass eine Abnahme der Ätzrate durch ein wachsendes Aspektverhältnis der Unterätzkanäle auftritt. Beispielsweise ist es mit diesen Gasen, insbesondere mit ClF₃, möglich, dass die laterale Ausdehnung der Unterätzkanäle ein Vielfaches, beispielsweise 100 bis 1000, von deren vertikaler Ausdehnung ausmacht, ohne dass nachteilige Auswirkungen auf den Ätzprozess entstehen.

Schließlich erfolgt die isotrope Ätzung mit diesen Gasen völlig ohne Ioneneinwirkung, was hinsichtlich der gewünschten Isotropie und Selektivität gegenüber NichtSiliziummaterialien von großem Vorteil ist.

Insgesamt ist ClF₃ in vielerlei Hinsicht ein ideales Gas zum selektiven Entfernen von Silizium oder porösen Silizium im Rahmen einer Opferschichttechnik, so dass sich damit sehr einfach freitragende Membranstrukturen bei minimalen Einschränkungen der Designfreiheit realisieren lassen. Vielfach genügt sogar eine einzige Ätzöffnung, um eine vollständige Unterätzung eines Membranbereiches auf beispielsweise porösen Silizium zu erzielen. Nachteilig beim Einsatz von ClF3 und mit Einschränkung auch von BrF₃ ist andererseits, dass es sich sehr leicht umgebremst über Mikrokanalstrukturen oder sogar Nanokanalstrukturen ausbreitet, so dass die Gefahr groß ist, dass aufgebrachte Passivierschichten, beispielsweise teflonartige Seitenwandpassivierschichten gemäß DE 42 41 045 C1, über Mikro- oder Nanorisse im Grenzflächenbereich zu Silizium extrem schnell hinterkrochen werden.

So hat sich gezeigt, dass eine teflonartige, aus C₄F₈ oder C₃F₆ erzeugte Plasmapassivierschicht genügend viele Mikrokanäle bzw. Nanokanäle im Grenzflächenbereich zu dem darunter befindlichen Silizium aufweist, um ausgehend von einer einzigen Einlassöffnung, beispielsweise auf dem Ätzgrund des zunächst erzeugten Trenchgrabens, die gesamte MEMS-Struktur trotz der aufgebrachten teflonartigen Passivierung großflächig einem ClF₃-Ätzangriff auszusetzen. Ein typisches Fehlerbild ist dabei, dass Strukturen, bei denen der Ätzgrund zuvor ionenunterstützt gemäß DE 42 41 045 C1 von einem passivierenden Teflonpolymer freigeräumt wurde, massiv auf der gesamten, an sich passivierten Seitenwandfläche angeätzt wird, während Strukturen, bei denen der Ätzgrund nur einen wenige Nanometer dicken Rest eines teflonartigen Polymers trägt, auch nach langer Zeit nirgends Anzeichen eines Ätzangriffes zeigen. Ursache dieses Problems sind die erläuterten Mikrokanäle bzw. Nanokanäle im Grenzflächenbereich zwischen der auf Silizium an sich schlecht haftenden Teflonpassivierung und der Siliziumoberfläche, die dem Ätzgas ClF₃ Zutritt zum Silizium an unerwünschten Stellen gewähren.

In XP010377139 wird eine Schutzschicht vorgeschlagen, die eine SiO₂-Schicht und eine polymerische Schicht enthält.

Aufgabe der vorliegenden Erfindung war die Bereitstellung einer Passivierschicht auf einer Siliziumschicht sowie eines Verfahrens zur Erzeugung einer derartigen Passivierschicht auf einer Siliziumschicht, die eine verstärkte Passivierung der Grenzfläche zwischen der Passivierschicht und der Siliziumschicht durch Vermeidung der Ausbildung oder alternativ einem Verschluss von unerwünschten mikroskaligen oder nanoskaligen Kanälen leistet, über die ansonsten ein unkontrollierter Ätzangriff, insbesondere durch ein isotrop ätzendes Gas wie ClF₃ oder BrF₃, erfolgen könnte. Daneben sollte das Verfahren und das erhaltene Schichtsystem mit der Passivierschicht in mit einer Fotolackmaskierung arbeitende Plasmaätzverfahren zur Erzeugung von Trenchgräben und freitragenden Strukturen integrierbar sein.

### Vorteile der Erfindung

Das erfindungsgemäße Schichtsystem gemäß Anspruch 1 und das erfindungsgemäße gemäß Anspruch 12 hat gegenüber dem Stand der Technik den Vorteil, dass damit ein sehr guter Schutz einer Siliziumschicht insbesondere gegenüber einem Ätzangriff mit hochoxidierenden Fluorverbindungen wie ClF₃ oder BrF₃ durch reaktive Passivierung auf atomarer oder molekularer Ebene insbesondere durch Inertisierung der Bindungsplätze einer Siliziumoberfläche erreicht wird, und dass zumindest nahezu keine mikroskaligen oder nanoskaligen Kanäle in der Passivierschicht vorliegen, durch die eines dieser Gase die geschützte Siliziumschicht angreifen könnte. Insofern eignet sich das erfindungsgemäße Schichtsystem und das erfindungsgemäße Verfahren vor allem zum Einsatz bei der Erzeugung von zumindest weitgehend oder bereichsweise freitragenden Strukturen in Silizium, die zeitweilig eine anisotrope Ätztechnik, beispielsweise gemäß DE 42 41045 C1, und zeitweilig eine isotrope Unterätztechnik, beispielsweise gemäß DE 44 20 962 C2 oder DE 198 47 455 A1, einsetzen.

Weiter ist vorteilhaft, dass das erfindungsgemäße Verfahren und das erfindungsgemäße Schichtsystem in Ätzprozesse integrierbar ist, die mit einer Fotolackmaske zur Erzeugung von Trenchgräben arbeiten, so dass nicht auf eine in diesen Prozessen an sich nicht erforderliche, teurere und aufwändigere Hartstoffmaskierung zurückgegriffen werden muss. Vorteilhafte Weiterbildungen der Erfindung ergeben sich aus den in den Unteransprüchen genannten Maßnahmen.

So ist vorteilhaft, dass das Problem des Hinterkriechens des Grenzflächenbereiches zwischen der Passivierschicht und der Siliziumschicht durch eine hochoxidierende Fluorverbindung wirksam dadurch verhindert werden kann, dass der Grenzflächenbereich zunächst durch eine dünne oxidische Passivierung versiegelt wird, auf die dann die zweite Teilschicht in Form einer sogenannten "Self Assembled Monolayer" (SAM-Schicht) aufgebracht wird. Dies stellt sicher, dass alle reaktionsfähigen Bindungsplätze der Oberfläche der Siliziumschicht inertisiert und gegen den Angriff der hochoxidierenden Fluorverbindungen unempfindlich sind. Falls eine derartige Passivierschicht dann noch nicht ausreichend dick sein sollte, um auch einem länger andauernden Ätzprozess standzuhalten, kann sie dann weiter vorteilhaft mit einer zusätzlich auf der zweiten Teilschicht aufgebrachten teflonartigen Schicht verstärkt werden.

Grundsätzlich stellt bereits eine lediglich 1 nm bis 2 nm dünne Oxidschicht als erste Teilschicht, die beispielsweise aus einer Plasmaoxidation der Oberfläche der Siliziumschicht herrührt, eine geeignete Passivierung auf atomarer Ebene dar, die von hochoxidierenden Fluorverbindungen nicht hinterkrochen würde, die aber aufgrund ihrer geringen Dicke einem Ätzangriff nur kurz standhält. Insofern tritt bei dem Versuch, eine nur wenige Nanometer dicke Oxidpassivierung einer Siliziumoberfläche durch ein beispielsweise mit einem Plasma abgeschiedenes teflonartiges Polymer zu verstärken, insbesondere in Verbindung mit einem in der Regel unvermeidbaren Ioneneintrag auf Strukturseitenwände bereits eine Beschädigung der Oxidpassivierung ein.

Eine von vielen möglichen unerwünschten Ätzreaktionen in Verbindung mit dem Prozessgas C₄F₈ zur Erzeugung von teflonbildenden Monomeren verläuft dabei gemäß:

SiO₂ + (CF₂)₄ → SiF₄+(CO)₂(CF₂)₂

Es ist somit nicht möglich, eine teflonartige Schicht auf eine atomare Siliziumoxidpassivierung im Plasma zumindest annähernd konform abzuscheiden, ohne dabei eine Beschädigung oder einen Abtrag der Oxidpassivierung in Kauf nehmen zu müssen.

Besonders vorteilhaft ist weiter, wenn die Passivierung einer Siliziumstruktur oder Siliziumschicht zunächst mit einer Einwirkung eines Plasmas aus Siliziumtetrafluorid und einem Sauerstoffträger auf das Siliziumsubstrat beginnt, wobei das Substrat weiter bevorzugt vorausgehend einem O₂-Reinigungsschritt in einem Plasmastripper zu Entfernung von organischen Resten, beispielsweise auf Seitenwänden, und einer anschließenden Plasmaoxidation, beispielsweise von Seitenwandoberflächen, vorbehandelt wurde. Nach dieser optionalen Vorbehandlung wird durch eine Reaktion des Siliziumtetrafluorids mit dem Sauerstoffträger eine Siliziumoxidschicht beispielsweise mit einer Dicke von 10 nm bis 20 nm über dem gegebenenfalls bereits vorhandenen nativen bzw. durch Plasmaoxidation erhaltenen Oberflächenoxid auf der Siliziumschicht aufgewachsen, so dass sich die erste Teilschicht der Passivierschicht ausbildet oder sich in ihrer Dicke vergrößert.

Als besonders vorteilhaft hat sich weiter herausgestellt, wenn zur Passivierung der Siliziumoberfläche auf der anorganischen Teilschicht sogenannte "Self-Assembled-Monolayers" (SAM-Schicht) von organischen Fluorsilanen oder organischen Fluorchlorsilanen (sogenannte "F-TCS") wir CF₃(CF₂)ₙC₂H₂SiCl₃ eingesetzt werden. Daneben sind "Self-Assembled-Monolayers" (SAM) aus organischen Verbindung der allgemeinen Formel Rₐ-R_{b}-Si(X)₃₋ₙ-(R_{c})ₙ vorteilhaft, wobei Rₐ ein perfluorierter Polyether oder eine perfluorierte Alkylgruppe mit 1 bis 16 Kohlenstoffatomen, vorzugsweise 6 bis 12 Kohlenstoffatomen, R_{b} ein Alkylspacer, beispielsweise ein Methyl- oder Ethylspacer, R_{c} eine Alkylgruppe, beispielsweise eine Methyl- oder Ethylgruppe, und X ein Halogen, eine Acetoxy- oder eine Alkoxy-Gruppe ist, und wobei n einen Wert von 0 bis 2 hat. Besonders geeignet sind 1,1,2,2-Perfluortetrahydrododecyltrichlorsilan, 1,1,2,2-Perfluortetrahydrododecyltrimethoxysilan, 1,1,2,2-Tetrahydroperfluordecyltrichlorsilan, 1,1,2,2-Tetrahydroperfluordecyltrimethoxysilan, 1,1,2,2-Tetrahydroperfluordecyltriacetoxysilan, 1,1,2,2-Tetrahydroperfluordecyltriethoxysilan, 1,1,2,2-Tetrahydroperfluoroctyltrichlorsilan, 1,1,2,2-Tetrahydroperfluoroctyltrimethoxysilan, 1,1,2,2-Tetrahydroperfluordecyltriethoxysilan, 1,1,2,2-Perfluortetrahydrohexyltrichlorsilan, 1,1,2,2-Perfluortetrahydrohexyltriethoxysilan oder 1,1,2,2-Perfluortetrahydrohexyltrimethoxysilan. Darüber hinaus eignen sich auch Chlorsilane oder Silane mit anderen funktionellen Gruppen wie Siloxane mit funktionellen Sauerstoff- oder OH-Gruppen, wie sie von der Firma Degussa AG unter dem Handelsnamen Dynasilan-F vertrieben werden.

Insbesondere ist bei den genannten Verbindungen vorteilhaft, dass die anorganischen funktionellen Gruppen der Silanverbindung die Anbindung an die Silizium- bzw. Siliziumoxidoberfläche sicherstellen, während die (per)fluorierten organischen Alkylketten eine inerte, teflonartige Oberfläche ausbilden.

Die Abscheidung der genannten "self assembled monolayers" kann vorteilhaft sowohl aus der Gasphase als auch aus der Flüssigphase mit Hilfe geeigneter Lösungsmittel durchgeführt werden. Für eine Gasphasenabscheidung wird die einzusetzende Verbindung verdampft, um dann aus der Gasphase die betreffende zweite Teilschicht der Passivierschicht zu erzeugen. Für eine Flüssigphasenabscheidung bieten sich für Fluorsilane Lösungsmittel wie n-Heptan, n-Hexan oder c-Hexan sowie bevorzugt Fluorcarbone an, also perflourierte Alkane, wie sie beispielsweise von der Firma 3M vertrieben werden. Diese Fluorcarbone lösen Fluorsilane sehr gut, haben eine extrem niedrige Oberflächenspannung, und können so selbst in feinste Strukturen eindringen und alle zu passivierenden Oberflächen erreichen. Weiter ist sowohl die Abscheidung aus der Gasphase als auch aus der Flüssigphase ohne eine Beschädigung eines vorhandenen Siliziumoxids als erste anorganische Teilschicht möglich, da diese Verfahren plasmalos ablaufen.

Nach dem Aufbringen eines beispielsweise aus einem Fluorsilan gebildeten "self assem bled monolayer" (SAM-Schicht) kann dieser bei Bedarf im Weiteren vorteilhaft selektiv über ein kurzes Plasmaätzen, beispielsweise ein SF₆- oder C₄F₈- oder Ar-Plasmaätzen, auch wieder, insbesondere im Bereich des Bodens eines Trenchgrabens, abgetragen werden, so dass nachfolgend unter Einsatz hochoxidierender Fluorverbindungen eine Unterätzung von Strukturen in Silizium erfolgen kann, wobei das beispielsweise aufgebrachte Fluorsilan in Verbindung mit dem Siliziumoxid die erforderliche Passivierung bereitstellt. In diesem Fall wird lediglich mit einer molekularen Passivierung gearbeitet, die aus der Schichtkombination aus einem Fluorsilan und einem Siliziumoxid besteht und typischerweise nur etwa 2 nm bis 10 nm dick ist. Aufgrund der exzellenten Selektivität hochoxidierender Fluorverbindungen wie ClF₃ oder BrF₃ gegenüber der teflonartigen Oberfläche eines Fluorsilans reicht diese Passivierung für eine begrenzte Unterätzzeit aus, die in vielen Anwendungsfällen hinreichend ist.

In vielen Fällen ist jedoch vorteilhaft, die "primäre" Passivierung durch zusätzliche Abscheidung einer wesentlich dickeren, teflonartigen Schicht aus einer Plasmaentladung gemäß dem in DE 42 41 045 C1 beschriebenen Verfahren mit beispielsweise C₄F₈ oder C₃F₆ oder auch C₄F₆ oder C₅F₈ als teflonbildende Monomere lieferndes Passiviergas zu verstärken. Die beiden letzten genannten Passiviergase vernetzen besonders gut und bilden vorteilhaft besonders dichte, in sich quer vernetzte Teflonschichten (sogenanntes "cross-link"). Damit wird ein teflonartiger Film über der zweiten Teilschicht erzeugt, ohne dass durch Einwirkung von Ionen und (CF₂)ₙ-Radikalen eine Beschädigung der ersten, anorganischen Teilschicht auftritt. Insbesondere lässt sich auf diese Weise ohne Angriff auf die erste Teilschicht die Passivierschicht mit einer beispielsweise 100 nm bis 200 nm dicken, teflonartigen Schicht verstärken, so dass man eine besonders dichte, über lange Zeit einem Ätzangriff standhaltende Passivierung einer Siliziumoberfläche erhält.

Schließlich ist vorteilhaft, dass auf der zweiten Teilschicht beispielsweise aus einem Fluorsilan, die einerseits eine teflonartige Oberfläche in Form von perfluorierten Alkylgruppen anbietet, und andererseits dank der funktionellen Silangruppe ausgezeichnet auf einer Silizium- oder Siliziumoxidoberfläche haftet, die darauf insbesondere aus einem Plasma abgeschiedene Teflonschicht ausgezeichnet haftet und gleichzeitig besonders dicht ist.

Der zweiten Teilschicht kommt in diesem Fall somit nicht nur die Rolle einer primären Oberflächenpassivierung zu, sondern auch die Rolle eines Haftvermittlers zu einer weiteren, darauf erzeugten teflonartigen Schicht. Dadurch erhält man nicht nur ein dichtes, intaktes Oxidinterface auf der Siliziumschicht, sondern auch eine dicke, widerstandsfähige und gut haftende, die Oberfläche bildende teflonartige Schicht auf der zweiten Teilschicht.

### Zeichnungen

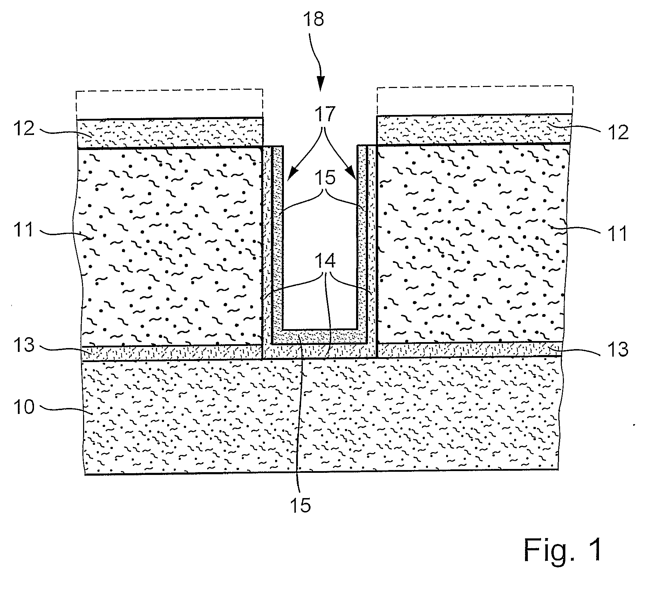

Die Erfindung wird anhand der Zeichnung und der nachfolgenden Beschreibung näher erläutert. Es zeigt Figur 1 eine Prinzipsskizze eines Schnittes durch ein Schichtsystem mit einer Strukturierung in Form eines Trenchgrabens.

### Ausführungsbeispiele

Ein Ausführungsbeispiel eines Schichtsystems mit einer Siliziumschicht und einer bereichsweise oberflächlich aufgebrachte Passivierschicht sowie das Verfahren zur Herstellung einer derartigen Passivierschicht auf einer Siliziumschicht wird mit Hilfe der Figur 1 erläutert. Insbesondere geht man zunächst von einem Siliziumwafer aus, der ein für eine Prozessierung gemäß DE 198 47 455 A1 geeignetes Schichtsystem mit vergrabenen Oxidschichten, Polysiliziumschichten und einer funktionalen Siliziumschicht trägt, auf der eine Fotolackmaskierung aufgebracht ist, die die in der Siliziumschicht zu erzeugenden Strukturen definiert.

In Figur 1 ist dazu auf einem nicht dargestellten Substrat und gegebenenfalls vorhandenen vergrabenen Oxidschichten eine erste Siliziumschicht 10 beispielsweise aus Polysilizium vorgesehen, auf der sich eine Trennschicht 13, beispielsweise aus Siliziumoxid, befindet. Auf der Trennschicht 13 ist eine zweite Siliziumschicht 11 als funktionale Siliziumschicht aufgebracht, auf der sich eine Lackmaske 12 befindet. Weiter ist in Figur 1 zu erkennen, dass mit Hilfe der Fotolackmaske 12 bereichsweise ein Trenchgraben 18 in die zweite Siliziumschicht 11 eingeätzt worden ist, der bis zu der ersten Siliziumschicht 10 reicht, d. h. dieser durchquert auch die Trennschicht 13.

Konkret wird nach einer Fotoprozessierung zur Erzeugung der Lackmaske 12 mit dem Prozess gemäß DE 42 41 045 C1 der Trenchgraben 18 in die zweite Siliziumschicht 11 eingeätzt, die beispielsweise aus einem 11 µm dicken Epipolysilizium besteht. Dieser Prozess stoppt automatisch auf der Trennschicht 13 aus einem Isolationsoxid, das gemäß der Lehre von DE 198 47 455 A1 die funktionale zweite Siliziumschicht 11 von der ersten Siliziumschicht 10 trennt. Die Dicke der ersten Trennschicht 13 beträgt im Bereich des Trenchgrabens 18 beispielsweise 50 nm bis 100 nm. Die zweite Siliziumschicht 11 dient beispielsweise der Erzeugung von freitragenden Strukturen darin.

Mittels eines nachfolgenden Oxidätzschrittes wird dann zunächst die Trennschicht 13 selektiv gegenüber Silizium und selektiv gegenüber der Fotolackmaskierung aus dem Trenchprozess gemäß DE 42 41045 C1 mit Hilfe eines Plasmas durchgeätzt.

Als geeignetes, selektiv agierendes Prozessgas wird beispielsweise CHF₃, C₂F₆, C₃F₆, C₄F₆, C₅F₈, C₄F₈ oder ein Gemisch eines dieser Gase mit CF₄ eingesetzt. Bevorzugt wird für den Oxidätzschritt C₄F₈ oder ein Gemisch von C₄F₈ mit CF₄ verwendet. Der Zusatz von CF₄ dient dabei vor allem dazu, eine Polymerbildung im Plasma während der Ätzung der Trennschicht 13, d. h. von SiO₂, zu kontrollieren, wobei jedoch zu beachten ist, dass ein Zusatz von CF₄ zu einer Verschlechterung der Selektivität der Ätzung von SiO₂ gegenüber Silizium oder Fotolack führt.

Nach dem Durchätzen der Trennschicht 13 und einem relativen Stop des Oxidätzprozesses auf der ersten Siliziumschicht 10 werden zunächst undefinierte teflonartige Schichten auf den Seitenwänden bzw. dem Boden des Trenchgrabens 18, wie sie aus dem Prozess gemäß DE 42 41 045 C1, der zuvor durchgeführt wurde, noch vorhanden sein können, mittels einem Sauerstoffplasma entfernt. Anschließend werden die freigelegten Siliziumoberflächen kontrolliert mit einem möglichst dichten Oxid, vorzugsweise Siliziumoxid, versehen. Das initiale oder native Oxid entstand dabei bevorzugt bereits durch Oberflächenoxidation während der vorausgehend O₂-Plasmaentladung zur Entfernung von Polymerresten.

Hierzu wird der Wafer mit dem Schichtaufbau gemäß Figur 1 nach dem Plasmaätzschritt zum Ätzen der Trennschicht 13 zunächst einer Plasmaoxidation unterzogen, vorzugsweise in einem O₂-Plasmastripper. In dem dort vorliegenden Sauerplasma werden einerseits undefinierte teflonartige Reste entfernt, und andererseits werden darin zugängliche Siliziumoberflächen oxidiert, so dass sich ein dichtes Oberflächenoxid bildet.

Dieses "gewachsene"Oberflächenoxid auf der ersten Siliziumschicht 10 bzw. der zweiten Siliziumschicht 11 kann dann mit einem vorzugsweise unmittelbar danach darauf abgeschiedenen Siliziumoxid unter Verwendung des Prozesses gemäß DE 197 06 682 A1, d. h. mit Hilfe von SiF₄ und einem Sauerstoffträger, zunächst verstärkt werden. Auf diese Weise bildet sich auf den Seitenwänden der zweiten Siliziumschicht 11 bzw. auf der zugänglichen Oberfläche der ersten Siliziumschicht 10 gemäß Figur 1 eine erste, anorganische Teilschicht 14 aus, die im erläuterten Beispiel zumindest näherungsweise aus Siliziumdioxid (SiO₂) besteht.

Im Übrigen sei erwähnt, dass während der Entfernung der teflonartigen Reste des Vorprozesses und der Oberflächenoxidation in dem Sauerstoffplasmastripper unvermeidlich auch die Lackmaske 12 teilweise mit abgetragen wird, so dass sich deren Dicke reduziert. Dies ist in Figur 1 durch eine gestrichelte Linie dargestellt, die die größere Dicke der Lackmaske 12 vor dem Zustand gemäß Figur 1 repräsentiert. Insbesondere muss dieser Prozess so geführt werden, dass für den nun durchgeführten Folgeprozess noch eine ausreichend dicke Lackmaske 12 verblieben ist d. h. beispielsweise eine Lackmaske 12 mit einer Dicke von 200 nm bis 500 nm ausgehend von einer Fotolackschicht mit einer ursprünglichen Dicke von 1000 nm bis 2000 nm.

In einem nächsten Schritt wird dann die Oberfläche der ersten, anorganische Teilschicht 14 hydrophiliert. Im erläuterten Beispiel werden dazu unter Einwirkung von Wasser Si-OH-Gruppen an der Siliziumoxidoberfläche erzeugt. Dies geschieht beispielsweise durch Einstellen des wie erläutert behandelten Siliziumwafers für beispielsweise eine Stunde in ein Wasserbad. Bevorzugt wird der Siliziumwafer in eine Reaktionskammer, beispielsweise in eine ohnehin vorbereitete Reaktionskammer für das nachfolgende Erzeugen der zweiten Teilschicht 15 eingebracht, und darin mit Wasserdampf behandelt. Dieses Vorgehen erreicht die gewünschte Hydrophilierung, ohne dass ein anschließendes Entfernen akkumulierter Flüssigkeit, insbesondere aus schmalen Trenchgräben, erforderlich wäre. Im Übrigen ist vorteilhaft, wenn der Wasserdampf zuvor oder dabei einer zusätzlichen Plasmaaktivierung unterzogen wird, da dies seine Wirksamkeit hinsichtlich der gewünschten Hydrophilierung erhöht. Eine ausreichend Hydrophilierung, d.h. eine ausreichende Bildung von OH-Gruppen auf der Oberfläche, ist sehr förderlich für die Zuverlässigkeit des Aufbringens der im Weiteren erzeugten zweiten Teilschicht 15 und deren versiegelnde Wirkung.

Nach diesem Verfahrensschritt und einem Entfernen des Wasserdampfes aus der Reaktionskammer, beispielsweise durch Evakuieren und Ausheizen, wird das zur Bildung der "self assembled monolayer" ausgewählte organische Fluorsilan oder Fluorchlorsilan (F-TCS) in die Reaktionskammer eingelassen. Die dabei auftretenden Oberflächenreaktionen können wie folgt beispielhaft beschrieben werden, wobei sukzessive an OH-Gruppen der Oberfläche der ersten Teilschicht 14 ein oder mehrere Trichlorsilanmoleküle angebunden werden bzw. auch untereinander quervernetzen:

X-SiCl₃ + =Si(OH)₂ → (X-SiCl₂O)(OH)Si= + HCl X-SiCl₃+(X-SiCl₂O)(OH)Si= → (X-SiCl₂O)₂Si=+HCl

oder:

(X-SiCl₂-O)(OH)Si= → (X-SiClO₂)Si= + HCl (X-SiClO₂)Si= + =Si(OH)₂ → =Si(OH)(X-SiO₃)Si= + HCl

Die Bezeichnung "=Si(OH)₂" bzw. "=Si" bedeutet dabei, dass es sich um ein an den Festkörper gebundenes Siliziumatom an der Oberfläche der ersten Teilschicht 14 handelt, das oberflächlich zwei Hydroxylgruppen trägt, und das zwei Bindungen "=" an andere Siliziumatome aufweist. X steht beispielsweise für eine Gruppe der Form (CF₃)(CF₂)ₙC₂H₂-mit perfluoriertem Alkylrest, um eine teflonartige Oberfläche zu generieren.

Nach Aufbau der "self assembled monolayer" (SAM-Schicht) wird das organische Fluorsilan oder Fluorchlorsilan aus der Reaktionskammer abgepumpt und nachfolgend bevorzugt erneut Wasserdampf eingelassen, um nicht abreagiertes Chlor durch HCl-Bildung zu entfernen. Damit wird erreicht, dass die gebildete "self assembled monolayer", die die zweite Teilschicht 15 definiert, kein Chlor mehr enthält, so dass keine davon verursachte Korrosionseffekte auftreten können. Daneben wird damit eine Quervernetzung innerhalb der zweiten Teilschicht 15 verstärkt.

Anstelle der erläuterten Gasphasenreaktion ist es auch möglich, die als SAM ausgebildete zweite Teilschicht 15 durch Eintauchen des vorbehandelten Siliziumwafers in eine Lösung des eingesetzten organischen Fluorsilans oder Fluorchlorsilans in einem Fluorkarbon, beispielsweise in dem Produkt FC43 der Firma 3M oder ähnlichen Perfluoralkanen, durchzuführen. In diesem Fall wird bevorzugt auch die vorangehende Hydrophilierung und die nachträgliche Entfernung von Chlorresten in einem Wasserbad durchgeführt, wobei auf eine zuverlässige Trocknung zwischen den Einzelschritten zu achten ist. Im Weiteren kann dann optional eine zusätzliche teflonartige Schicht, d. h. eine Schicht mit der Struktur -(CF₂)ₙ- durch Plasmapolymerisation gemäß DE 42 41 045 C1 auf der zweiten Teilschicht 15 aufgebracht werden. Da die zweite Teilschicht 15 aufgrund von im erläuterten Beispiel vorhandenen langen Perfluoralkylketten bereits eine Dicke von typischerweise 5 nm bis 20 nm besitzt, tritt während der Abscheidung der zusätzlichen teflonartigen Schicht keine Schädigung der ersten Teilschicht 14 auf. Die Dicke der zusätzlichen teflonartigen Schicht liegt bevorzugt bei 50 nm bis 300 nm, insbesondere 100 nm bis 200 nm.

Die Passivierung der Siliziumschicht 11 durch die Passivierschicht 17 ist nun abgeschlossen, so dass ein Zutritt von hochoxidierenden Fluorverbindungen wie ClF₃ zu dieser und auch ein ungewolltes Hinterschneiden der Passivierschicht 17 unterbleibt.

Zusammenfassend wird durch das vorstehend erläuterte Verfahren auf der ersten Siliziumschicht 10, die im Bereich des Bodens des Trenchgrabens 18 zugänglich ist, sowie auf der zweiten Siliziumschicht 11, die im Bereich der Seitenwände des Trenchgrabens 18 zugänglich ist, zunächst als erste anorganische Teilschicht 14 eine dünne Siliziumoxidschicht abgeschieden. Auf der ersten, anorganischen Teilschicht 14 befindet sich dann die zweite Teilschicht 15, auf der optional eine weitere Schicht in Form einer teflonartigen Schicht vorgesehen sein kann.

Zu einer Erzeugung einer freistehenden MEMS-Struktur kann abschließend, ausgehend von dem Stadium gemäß Figur 1, durch einen vergleichsweise kurzen Ätzschritt unter Verwendung von SF₆ oder CF₄, C₂F₆, CHF₃, C₄F₈ oder eines Gemisches aus diesen Gasen mit SF₆ als Ätzgas mit Ionenunterstützung in einem Plasma am Boden des Trenchgrabens 18 die dort vorhandene Passivierschicht 17 zunächst selektiv durchbrochen, und anschließend beispielsweise mit Hilfe von ClF₃ oder BrF₃, d. h. einer hochoxidierenden Fluorchemie, eine isotrope Unterätzung einer freizulegenden MEMS-Struktur vorgenommen werden. Die Unterätzung kann zeitkontrolliert sein, oder durch eine Lateralbegrenzung von vergrabenen Polysilizium-Inseln, die es zu entfernen gilt, designgesteuert werden. Nach dem Abschluss der Unterätzung wird der Wafer dann aus der Ätzkammer ausgeladen, und es werden die verbliebene Lackmaske 12 und auch zumindest Teile der Passivierschicht 17 durch erneutes O₂-Plasmastrippen entfernt. Dabei können Reste der zweiten Teilschicht 15 ohne Nachteile für das Funktionieren der erzeugten MEMS-Strukturen zurückbleiben. Weiter können abschließend dünne Siliziumoxidschichten durch ein kurzes Überätzen in einem HF-Dampf überall dort entfernt werden, wo dies aus Gründen reduzierter mechanischer Spannungsgradienten gewünscht wird, beispielsweise auf der Unterseite einer freigelegten MEMS-Struktur. Dicke Oxidschichten, die beispielsweise eine Funktion als Isolationsschicht besitzen, werden von diesem kurzen HF-Dampfätzschritt nicht berührt.

## Patentansprüche

1. Schichtsystem mit einer Siliziumschicht (11), in die ein Trenchgraben (18) eingeätzt ist, wobei auf der Siliziumschicht (11) zumindest bereichsweise oberflächlich eine Passivierschicht (17) aufgebracht ist, wobei die Passivierschicht (17) eine erste, zumindest weitgehend anorganische Teilschicht (14) und eine zweite Teilschicht (15) aufweist, wobei die zweite Teilschicht (15) aus einer organischen Verbindung mit Silizium besteht oder eine einer organische Verbindung mit Silizium enthält, wobei die Passivierschicht (17) im Bereich der Seitenwände des Trenchgrabens (18) aufgebracht ist.

2. Schichtsystem nach Anspruch 1, **dadurch gekennzeichnet, dass** die organische Verbindung ein Halogen enthält.

3. Schichtsystem nach Anspruch 1 oder 2, **dadurch gekennzeichnet, dass** die organische Verbindung ein Silan, insbesondere ein organisches Fluorsilan oder ein organisches Fluorchlorsilan, oder ein Siloxan ist.

4. Schichtsystem nach einem der vorangehenden Ansprüche, **dadurch gekennzeichnet, dass** die organische Verbindung die allgemeine Formel Rₐ-R_{b}-Si(X)₃₋ₙ-(R_{c})ₙ hat, wobei Rₐ ein perfluorierter Polyether oder eine perfluorierte Alkylgruppe mit 1 bis 16 Kohlenstoffatomen, insbesondere 6 bis 12 Kohlenstoffatomen, R_{b} und Rc eine Alkylgruppe und X ein Halogen, eine Acetoxy- oder eine Alkoxy-Gruppe ist, und wobei n einen Wert von 0 bis 2 hat.

5. Schichtsystem nach einem der vorangehenden Ansprüche, **dadurch gekennzeichnet, dass** die erste Teilschicht (14) zumindest weitgehend aus einer Oxidschicht, insbesondere Siliziumoxid, besteht.

6. Schichtsystem nach einem der vorangehenden Ansprüche, **dadurch gekennzeichnet, dass** die erste Teilschicht (14) eine Dicke von 1 nm bis 100 nm, insbesondere 1 nm bis 20 nm, aufweist.

7. Schichtsystem nach einem der vorangehenden Ansprüche, **dadurch gekennzeichnet, dass** die erste Teilschicht (14) unmittelbar auf der Siliziumschicht (11) oder auf einer auf der Siliziumschicht (11) befindlichen Schicht aus Siliziumoxid aufgebracht ist.

8. Schichtsystem nach einem der vorangehenden Ansprüche, **dadurch gekennzeichnet, dass** die zweite Teilschicht (15) eine sogenannte "Self-Assembled Monolayer"-Schicht ist.

9. Schichtsystem nach einem der vorangehenden Ansprüche, **dadurch gekennzeichnet, dass** die zweite Teilschicht (15) eine Dicke von 0,5 nm bis 30 nm, insbesondere 5 nm bis 20 nm, aufweist.

10. Schichtsystem nach einem der vorangehenden Ansprüche, **dadurch gekennzeichnet, dass** die Passivierschicht (17) eine die Siliziumschicht (11) gegenüber einem Ätzangriff von einem gasförmigem Halogenfluorid wie ClF₃ oder BrF₃ schützende Schicht ist.

11. Schichtsystem nach einem der vorangehenden Ansprüche, **dadurch gekennzeichnet, dass** die Passivierschicht (17) frei von mikroskaligen oder nanoskaligen, für ein Gas wie ClF₃ oder BrF₃ oder einen Dampf durchlässigen Kanälen ist.

12. Verfahren zur Erzeugung einer Passivierschicht auf einer Siliziumschicht (11), in die ein Trenchgraben (18) eingeätzt ist, wobei auf der Siliziumschicht (11) zumindest bereichsweise eine erste, zumindest weitgehend anorganische Teilschicht (14) und auf der ersten Teilschicht (14) zumindest bereichsweise eine zweite, eine organische Verbindung mit Silizium enthaltende oder daraus bestehende Teilschicht (15) erzeugt wird, die die Passivierschicht (17) bilden, wobei die Passivierschicht (17) im Bereich der Seitenwände des Trenchgrabens (18) erzeugt wird.

13. Verfahren nach Anspruch 12, **dadurch gekennzeichnet, dass** die Oberfläche der ersten, anorganischen Teilschicht (14) vor dem Aufbringen der zweiten Teilschicht (15) zumindest bereichsweise hydrophiliert wird.

14. Verfahren nach Anspruch 12 oder 13, **dadurch gekennzeichnet, dass** auf die zweite Teilschicht (15) eine weitere teflonartige Beschichtung aufgebracht wird.

15. Verwendung des Schichtsystems oder des Verfahrens nach einem der vorangehenden Ansprüche bei der Erzeugung von zumindest weitgehend oder bereichsweise freitragenden Strukturen in Silizium, insbesondere mittels zeitweiligem Einsatz einer anisotropen Ätztechnik und zeitweiligem Einsatz einer isotropen Ätztechnik in Silizium.

## Claims

1. Layer system comprising a silicon layer (11) into which a trench (18) is etched, wherein a passivation layer (17) is applied on the silicon layer (11) superficially at least in regions, wherein the passivation layer (17) has a first, at least substantially inorganic partial layer (14) and a second partial layer (15), wherein the second partial layer (15) consists of an organic compound comprising silicon or contains an organic compound comprising silicon, wherein the passivation layer (17) is applied in the region of the sidewalls of the trench (18).

2. Layer system according to Claim 1, **characterized in that** the organic compound contains a halogen.

3. Layer system according to Claim 1 or 2, **characterized in that** the organic compound is a silane, in particular an organic fluorosilane or an organic fluorochlorosilane, or a siloxane.

4. Layer system according to any of the preceding claims, **characterized in that** the organic compound has the general formula Rₐ-R_{b}-Si(X)₃₋ₙ(R_{c})ₙ, wherein Rₐ is a perfluorinated polyether or a perfluorinated alkyl group having 1 to 16 carbon atoms, in particular 6 to 12 carbon atoms, R_{b} and R_{c} are an alkyl group and x is a halogen, an acetoxy group or an alkoxy group, and wherein n has a value of 0 to 2.

5. Layer system according to any of the preceding claims, **characterized in that** a first partial layer (14) at least substantially consists of an oxide layer, in particular silicon oxide.

6. Layer system according to any of the preceding claims, **characterized in that** the first partial layer (14) has a thickness of 1 nm to 100 nm, in particular 1 nm to 20 nm.

7. Layer system according to any of the preceding claims, **characterized in that** the first partial layer (14) is applied directly on the silicon layer (11) or on a layer of silicon oxide situated on the silicon layer (11).

8. Layer system according to any of the preceding claims, **characterized in that** the second partial layer (15) is a so-called "self-assembled monolayer".

9. Layer system according to any of the preceding claims, **characterized in that** the second partial layer (15) has a thickness of 0.5 nm to 30 nm, in particular 5 nm to 20 nm.

10. Layer system according to any of the preceding claims, **characterized in that** the passivation layer (17) is a layer which protects the silicon layer (11) against an etching attack by a gaseous halogen fluoride such as CLF₃ or BrF₃.

11. Layer system according to any of the preceding claims, **characterized in that** the passivation layer (17) is free of microscale or nanoscale channels permeable to a gas such as CLF₃ or BrF₃ or a vapour.

12. Method for producing a passivation layer on a silicon layer (11) into which a trench (18) is etched, wherein a first, at least substantially inorganic partial layer (14) is produced at least in regions on the silicon layer (11), and a second partial layer (15), which contains or consists of an organic compound comprising silicon, is produced at least in regions on the first partial layer (14), which form the passivation layer (17), wherein the passivation layer (17) is produced in the region of the sidewalls of the trench (18).

13. Method according to Claim 12, **characterized in that** the surface of the first, inorganic partial layer (14) is hydrophilized at least in regions before the second partial layer (15) is applied.

14. Method according to Claim 12 or 13, **characterized in that** a further Teflon-like coating is applied to the second partial layer (15).

15. Use of the layer system or of the method according to any of the preceding claims in the production of at least substantially or regionally self-supporting structures in silicon, in particular by means of temporary use of an anisotropic etching technique and temporary use of an isotropic etching technique in silicon.

## Revendications

1. Système de couches comprenant une couche de silicium (11) dans laquelle est gravée une tranchée (18), une couche de passivation (17) étant appliquée en surface au moins par zones sur la couche de silicium (11), la couche de passivation (17) comprenant une première couche partielle (14), au moins pour l'essentiel inorganique, et une deuxième couche partielle (15), la deuxième couche partielle (15) étant constituée d'un composé organique avec du silicium, ou contenant un composé organique avec du silicium, la couche de passivation (17) étant appliquée dans la zone des parois latérales de la tranchée (18).

2. Système de couches selon la revendication 1, **caractérisé en ce que** le composé organique contient un halogène.

3. Système de couches selon la revendication 1 ou 2, **caractérisé en ce que** le composé organique est un silane, en particulier un fluorosilane organique ou un fluorochlorosilane organique, ou un siloxane.

4. Système de couches selon l'une des revendications précédentes, **caractérisé en ce que** le composé organique a la formule générale Rₐ-R_{b}-Si(X)₃₋ₙ-(R_{c})ₙ, dans laquelle Rₐ est un polyéther perfluoré ou un groupe alkyle perfluoré ayant 1 à 16 atomes de carbone, en particulier 6 à 12 atomes de carbone, R_{b} et R_{c} sont des groupes alkyle et X est un halogène, un groupe acétoxy ou un groupe alcoxy, n ayant une valeur de 0 à 2.

5. Système de couches selon l'une des revendications précédentes, **caractérisé en ce que** la première couche partielle (14) est au moins pour l'essentiel constituée d'une couche d'oxyde, en particulier d'oxyde de silicium.

6. Système de couches selon l'une des revendications précédentes, **caractérisé en ce que** la première couche partielle (14) présente une épaisseur de 1 nm à 100 nm, en particulier de 1 nm à 20 nm.

7. Système de couches selon l'une des revendications précédentes, **caractérisé en ce que** la première couche partielle (14) est appliquée directement sur la couche de silicium (11) ou sur une couche d'oxyde de silicium se trouvant sur la couche de silicium (11).

8. Système de couches selon l'une des revendications précédentes, **caractérisé en ce que** la deuxième couche partielle (15) est ce que l'on appelle une couche "Self-Assembled Monolayer" (monocouche auto-assemblée).

9. Système de couches selon l'une des revendications précédentes, **caractérisé en ce que** la deuxième couche partielle (15) présente une épaisseur de 0,5 nm à 30 nm, en particulier de 5 nm à 20 nm.

10. Système de couches selon l'une des revendications précédentes, **caractérisé en ce que** la couche de passivation (17) est une couche protégeant la couche de silicium (11) d'une attaque par gravure par un fluorure d'halogène gazeux tel que ClF₃ ou BrF₃.

11. Système de couches selon l'une des revendications précédentes, **caractérisé en ce que** la couche de passivation (17) est exempte de canaux micrométriques ou nanométriques, perméables à un gaz tel que ClF₃ ou BrF₃, ou une vapeur.

12. Procédé de fabrication d'une couche de passivation sur une couche de silicium (11) dans laquelle est gravée une tranchée (18), dans lequel on produit sur la couche de silicium (11) au moins par zones une première couche partielle (14) au moins pour l'essentiel inorganique, et sur la première couche partielle (14) au moins par zones une deuxième couche partielle (15), contenant un composé organique avec du silicium ou constituée de ce dernier, qui forment la couche de passivation (17), la couche de passivation (17) étant produite dans la zone des parois latérales de la tranchée (18).

13. Procédé selon la revendication 12, **caractérisé en ce que** la surface de la première couche partielle inorganique (14) est au moins par zones hydrophilisée avant.application de la deuxième couche partielle (15).

14. Procédé selon la revendication 12 ou 13, **caractérisé en ce qu'**on applique sur la deuxième couche partielle (15) un revêtement supplémentaire de type Teflon.

15. Utilisation du système de couches ou du procédé selon l'une des revendications précédentes pour produire des structures au moins pour l'essentiel ou par zones en porte-à-faux dans du silicium, en particulier par utilisation intermittente d'une technique de gravure anisotrope et par utilisation intermittente d'une technique de gravure isotrope dans le silicium.
